# EUROPÄISCHE PATENTSCHRIFT

(11) **EP 0 656 432 B1**
(45) Veröffentlichungstag und Bekanntmachung des Hinweises auf die Patenterteilung: **10.03.1999**
(21) Anmeldenummer: 94115919.6
(22) Anmeldetag: 09.10.1994
(51) Int. Cl.: C25D 5/02, H05K 3/22

(54) **Verfahren zur Herstellung von Multilayern sowie Vorrichtung zur Durchführung dieses Verfahrens**
Method for making multilayers and apparatus for executing said method
Méthode pour la fabrication de multicouches et appareil pour la mise en oeuvre de cette méthode

(30) Priorität: 06.11.1993 DE 4337988
(43) Veröffentlichungstag der Anmeldung: 07.06.1995
(73) Patentinhaber: HANS HÖLLMÜLLER MASCHINENBAU GMBH & CO., D-71083 Herrenberg (DE)
(72) Erfinder: Markowski, Joachim, D-47608 Geldern (DE)
(74) Vertreter: Ostertag, Reinhard

(56) Entgegenhaltungen:
- EP-A- 0 167 326
- EP-A- 0 570 094
- DE-A- 3 800 890
- US-A- 5 106 454

## Beschreibung

Die Erfindung betrifft ein Verfahren zur Herstellung von Multilayern, bei welchem das Kupferoxid an den metallischen Bereichen schwarz- oder braunoxidierter Kupferlaminate vor deren Einbindung in die Multilayer zur Vermeidung der Bildung von Pinkringen zumindest teilweise reduziert wird.

Die Erfindung betrifft außerdem die Verwendung einer vorrichtung zur Durchführung dieses Verfahrens mit
a) einem Gehäuse;
b) einem Transportsystem, welches die Kupferlaminate in horizontaler Ausrichtung durch die Vorrichtung fördert;
c) einer Einrichtung, welche das Kupferoxid an den metallischen Bereichen der schwarz- oder braunoxidierten Kupferlaminate vor deren Einbindung in die Multilayer zur Vermeidung der Bildung von Pinkringen zumindest teilweise reduziert.

Unter "Pinkringen" wird ein Phänomen an elektrischen Multilayerplatten verstanden, welches deren optisches Erscheinungsbild beeinträchtigt und zumindest Zweifel an deren Funktionstauglichkeit und Zuverlässigkeit hervorruft. Multilayerplatten, welche auch nur "Multilayer" genannt werden, sind z.B. in der Veröffentlichung "Leiterplatten, Herstellung und Verarbeitung, von Herbert Bruch et al." beschrieben. Sie bestehen aus mehreren Lagen einzelner Kupferlaminate, die aufeinander gelegt und miteinander zu einer Platte verpreßt werden. Elektrische Verbindungen der Lagen untereinander erhält man mit Hilfe von Bohrungen, die durch die Multilayerplatte hindurchgeführt und an ihren Mantelflächen metallisiert sind. Die Kupferlaminate, welche die elektrischen Leitungsmuster enthalten, werden an den metallischen Bereichen zur besseren Haftung an den benachbarten isolierenden Schichten schwarz- oder braunoxidiert. Werden nunmehr in die zusammengesetzten Multilayer diejenigen Bohrungen eingebracht, über welche die metallischen Leitungsmuster in verschiedenen Schichten miteinander verbunden werden, kann es im Bereich dieser Bohrungen aufgrund mechanischer oder thermischer Einflüsse zu geringfügigen Beschädigungen des Verbundes zwischen den Kupferlaminaten und den angrenzenden isolierenden Schichten kommen. Werden zur Reinigung der Bohrlochwände und zur Vorbereitung der nachfolgenden Metallisierung die Kupferlaminate dann einer Säurebehandlung ausgesetzt, kann die Säure in die geschwächten Verbindungsstellen zwischen Kupferlaminat und benachbarter isolierender Schicht eindringen und dort verhältnismäßig rasch das Kupferoxid auflösen. Die Säure kann dann entlang der Kupferoxidschicht weiter in den Schichtenverbund vorstoßen; sich dort ablagernde Salzreste können zu Kurzschlüssen zwischen den Leiterbahnen führen. Dieses Phänomen ist äußerlich daran erkennbar, daß um die Bohrungen herum in den Kupferlaminaten Ringe entstehen, die rosa erscheinen und deshalb in Fachkreisen "Pinkringe" genannt werden.

Zur Vermeidung der Bildung derartiger Pinkringe bzw. der nachteiligen Säureeinwirkungen, welche die Pinkringe ein Anzeichen sind, ist z.B. durch die US-5 106 454 bekannt, das Kupferoxid an den metallischen Flächen der schwarz- oder braunoxidierten Kupferlaminate durch chemische Reduktionsmittel zu reduzieren. Die Reduktion verläuft dabei im allgemeinen nur teilweise, entweder bis zu metallischem Kupfer oder bis zu einwertigem Kupfer, wobei die gewünschte, die Haftung verbessernde Oberflächenstruktur der Kupferlaminate aber erhalten bleibt. Die reduzierte Oberflächenschicht läßt sich durch in den nachfolgenden Verfahrensschritten eingesetzte Säure nicht oder jedenfalls nicht mehr so schnell angreifen.

Die bekannte durch Chemikalien bewirkte Reduktion des Kupferoxides an schwarz- oder braunoxidierten Kupferlaminaten hat jedoch mehrere Nachteile: Zum einen sind die eingesetzten Reduktionschemikalien verhältnismäßig teuer; sie verbrauchen sich im Laufe der Zeit. Zum anderen benötigt die chemische Reduktion verhältnismäßig viel Zeit; die Reaktion springt erst mit einer gewissen Verzögerung nach Einbringung der Kupferlaminate in die Lösung des Reduktionsmittels an. Die lange Zeitdauer, welche für den chemischen Reduktionsvorgang erforderlich ist, spiegelt sich apparativ in langen Moduln wieder, in denen dieser Verfahrensschritt ausgeführt wird. Sowohl die Kosten der verwendeten Chemikalien als auch die Kosten des Moduls sind somit verhältnismäßig hoch. Alleine die laufenden Verbrauchskosten, die zur Reduktion erforderlich sind, werden pro Quadratmeter behandelten Kupferlaminats auf mehrere Mark geschätzt.

Aufgabe der vorliegenden Erfindung ist es, ein Verfahren und die Verwendung einer Vorrichtung der eingangs genannten Art aufzuzeigen, mit denen die Reduktion des Kupferoxides an den schwarz- oder braunoxidierten Kupferlaminaten rascher und preiswerter erfolgen kann.

Diese Aufgabe wird, was das Verfahren angeht, erfindungsgemäß dadurch gelöst, daß die Reduktion durch atomaren Wasserstoff erfolgt, der "in statu nascendi" unmittelbar an den Kupferlaminaten dadurch entsteht, daß diese in einem geeigneten Elektrolyten als Kathode einer Elektrolyse geschaltet werden.

Die elektrochemische Reduktion unter Einsatz atomaren Wasserstoffes, der erfindungsgemäß unmittelbar an den zu reduzierenden Flächen erfolgt, benötigt keinerlei teuren Chemikalien; Elektrolyte, welche in der Elektrolyse Wasserstoff kathodisch entwickeln, sind zu sehr geringen Kosten in großer Auswahl ohne weiteres verfügbar. Darüber hinaus erweist sich, daß die elektrochemische Reduktion außerordentlich rasch erfolgen kann, so daß also die Verweilzeit der Kupferlaminate in der Elektrolyse verhältnismäßig kurz gehalten werden kann. Bei geeigneten Stromdichten reichen wenige Sekunden durchaus aus.

Als Elektrolyt können insbesondere verdünntes NaOH oder eine Salzlösung, insbesondere eine Kochsalzlösung, verwendet werden.

Die Stromdichte während der Elektrolyse sollte zwischen 1 und 500, vorzugsweise zwischen 10 und 250, mA/cm² gehalten werden. Die für den jeweiligen Anwendungsfall geeignete Stromdichte läßt sich durch wenige Versuche innerhalb dieses Rahmens ermitteln, wobei selbstverständlich die Stromdichten so niedrig wie möglich bleiben sollten.

Grundsätzlich ist es möglich, die Reduktion vollständig ohne Einsatz spezieller Reduktionschemikalien durchzuführen. In bestimmten Fällen kann es sich jedoch zur weiteren Beschleunigung empfehlen, die Kupferlaminate während der Elektrolyse gleichzeitig einem im Elektrolyten gelösten chemischen Reduktionsmittel auszusetzen. Selbstverständlich ist die Menge chemischen Reduktionsmittels, die in diesem Falle benötigt wird, sehr viel geringer als bei den bekannten Verfahren, die keine elektrochemische Reduktion verwenden.

Bei einer bevorzugten Verfahrensvariante werden die Kupferlaminate nach einer anfänglichen elektrochemischen Reduktion einer chemischen Reduktion durch ein Reduktionsmittel unterzogen. Es hat sich nämlich herausgestellt, daß eine sehr kurze elektrochemische Reduktion die bei der bisher praktizierten rein chemischen Reduktion beobachtete Verzögerungszeit bis zum Einsetzen der Reaktion vollständig eliminiert.

Die oben geschilderte Aufgabe wird bei der Verwendung einer Vorrichtung der eingangs genannten Art dadurch gelöst, daß die Einrichtung c umfaßt:
d) eine Behandlungskammer, welche im dynamischen Gleichgewicht von Zufluß und Abfluß mit einem in der Elektrolyse Wasserstoff entwickelnden Elektrolyten bis zu einem bestimmten Pegel befüllbar ist, wobei die Kupferlaminate vom Transportsystem unterhalb des Pegels des Elektrolyten durch die Behandlungskammer hindurchgeführt werden;
e) eine Spannungsquelle;
f) mindestens eine Kontaktiereinrichtung, die innerhalb der Behandlungskammer angeordnet ist, sich senkrecht zur Bewegungsrichtung der Kupferlaminate über deren ganze Breite erstreckt und mit dem Minuspol der Spannungsquelle verbunden ist;
g) mindestens eine Anode, die in der Nähe des Bewegungsweges der Kupferlaminate angeordnet und mit dem Pluspol der Spannungsquelle verbunden ist.

Die Vorteile der erfindungsgemäß verwendeten Vorrichtung stimmen sinngemäß mit den oben geschilderten Vorteilen des erfindungsgemäßen Verfahrens überein; die erfindungsgemäß erzielbare kürzere Reduktionszeit spiegelt sich bei gleicher Leistung in einer geringeren Längsabmessung der Vorrichtung, bei gleicher Längsabmessung in einer Leistungssteigerung wieder.

Im allgemeinen empfiehlt es sich aus geometrischen Gründen, wenn mehrere Kontaktiereinrichtungen und Anoden in Bewegungsrichtung der Kupferlaminate hintereinander angeordnet sind.

Der Abstand benachbarter Kontaktiereinrichtungen sollte dabei kleiner als die Längsabmessung, vorzugsweise kleiner als die halbe Längsabmessung, der Kupferlaminate sein. Auf diese Weise bleiben die Kupferlaminate während des gesamten Durchganges durch die Behandlungskammer kathodisch geschaltet; bei dem angegebenen kleineren Abstand ist zudem gewährleistet, daß die Kupferlaminate immer an zwei Stellen aufliegen und daher weniger aus der vorgeschriebenen Bahn ausweichen können, was zu Kurzschlüssen führen könnte.

Wenn die Anode(n) zwischen den Kontaktiereinrichtungen angeordnet ist (sind), können sie aus geometrischen Gründen verhältnismäßig nahe an die vorbeiwandernden Kupferlaminate herangeführt werden, so daß nur geringe Spannungen erforderlich sind.

Bei dieser Ausgestaltung der erfindungsgemäß verwendeten Vorrichtung empfiehlt sich, daß die Anode(n) an den Seiten, die nicht dem Bewegungsweg der Kupferlaminate zugewandt sind, elektrisch isoliert ist (sind). Hierdurch wird eine direkte Elektrolyse zwischen den Anoden und den Kontaktiereinrichtungen ohne Einbeziehung der Kupferlaminate verhindert.

Bei einer besonders bevorzugten Ausführungsform der erfindungsgemäß verwendeten Vorrichtung ist (sind) die Kontiereinrichtung(en) jeweils von einer Kontaktwalze gebildet.

Alternativ kommen als Kontaktiereinrichtung(en) Bürsten oder Bürstenvorhänge in Frage.

Das zum Elektrolyten oben für das Verfahren ausgeführte gilt für die Vorrichtung entsprechend.

Schließlich ist bei einem weiteren Ausführungsbeispiel der Erfindung in Bewegungsrichtung der Kupferlaminate hinter der ersten Behandlungskammer eine zweite Behandlungskammer angeordnet, in welcher die Kupferlaminate einer Lösung eines chemischen Reduktionsmittels aussetzbar sind. Dies Bauweise wird dann gewählt, wenn die elektrochemische Reduktion eine nachfolgende rein chemische Reduktion beschleunigen soll.

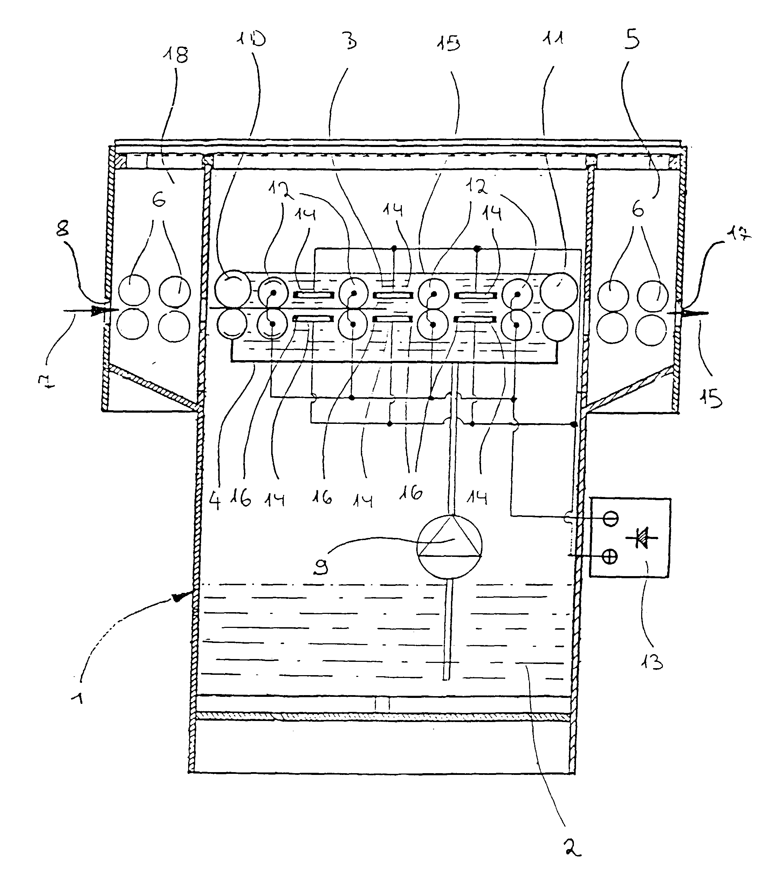

Ein Ausführungsbeispiel der Erfindung wird nachfolgend anhand der Zeichnung näher erläutert; die einzige Figur zeigt einen Längsschnitt durch denjenigen Teil einer Vorrichtung zur Herstellung von Multilayern, in welchem die Oxidschicht an schwarz- oder braunoxidiertem Kupferlaminat zur Vermeidung von "Pinkringen" reduziert wird.

Die in der Zeichnung dargestellte Vorrichtung ist Teil einer Produktionslinie, in welcher Multilayer hergestellt werden. Die gesamte Produktionslinie ist, entsprechend den verschiedenen Verfahrensschritten, modulartig zusammengestellt. Der gezeigten Vorrichtung vorangeschaltet ist demzufolge insbesondere ein Modul zu denken, in welchem die Kupferlaminate, die in einem späteren Verfahrensschritt zu der Multilayer zusammengefügt werden, schwarz- oder braunoxidiert werden. Nachgeschaltet sind der dargestellten Vorrichtung z.B. Spülmoduln sowie diejenigen Vorrichtungen, in denen die einzelnen Laminate zur fertigen Multilayern zusammengefügt werden.

Die in der Zeichnung dargestellte Vorrichtung umfaßt ein Gehäuse 1, in dessen Bodenbereich ein Sumpf 2 für einen Elektrolyten ausgebildet ist. Bei dem Elektrolyten kann es sich beispielsweise um 5-prozentiges Natriumhydroxid handeln. Geeignet ist jeder Elektrolyt, der an kathodisch geschaltetem Kupfer elektrolytisch Wasserstoff entwickelt und im übrigen mit den Materialien der Vorrichtung kompatibel ist. Grundsätzlich wären auch Salzlösungen, insbesondere NaCl-Lösungen, geeignet; hier müßten aber besondere Vorsorgemaßnahmen getroffen werden, damit eine Cl²-Bildung vermieden wird.

Die im vorausgegangenen Verfahrensschritt schwarz- oder braunoxidierten Kupferlaminate 3 treten in das Gehäuse 1 im Sinne des Pfeiles 7 durch einen Eintrittsschlitz 8 ein. Sie werden dabei durch ein Fördersystem in horizontaler Ausrichtung bewegt, welches beispielsweise aus einer Vielzahl von Rollen- oder Walzenpaaren 6 besteht. Zwei derartige Rollenoder Walzenpaare 6 sind in einem Einlaufteil 4 des Gehäuses 1 dargestellt. Ein besonderes Leitsystem, welches in der Zeichnung nicht dargestellt, als solches aber bekannt ist (vgl. z. B. die DE-PS 28 51 510), sorgt dafür, daß die Kupferlaminate sich nicht ausbiegen sondern im wesntlichen in der Förderebene verbleiben.

Aus dem Einlaufteil 4 des Gehäuses 1 gelangen die Kupferlaminate 3 in den Innenraum einer eine Behandlungskammer bildenden Wanne 4, deren in Bewegungsrichtung der Kupferlaminate 3 gesehen vordere Stirnwand von einem Stauwalzenpaar 10 und deren in Bewegungsrichtung gesehen hintere Stirnwand von einem Stauwalzenpaar 11 gebildet wird. Die Kupferlaminate 3 bewegen sich durch den Spalt des Stauwalzenpaares 10 in das Innere der Wanne 4 und werden dort von Kontaktwalzenpaaren 12 erfaßt, die neben einer unten noch zu beschreibenden Funktion als Kontaktiereinrichtung innerhalb der Wanne 4 gleichzeitig die Rolle des Transportsystemes übernehmen. Sie können aus den oben erwähnten Gründen mit demselben Leitsystem wie die Rollen- oder Walzenpaare 6 ausgestattet sein. Die Kontaktwalzenpaare 12 sind elektrisch mit dem Minuspol einer Spannungsquelle 13 verbunden.

Zwischen in Bewegungsrichtung aufeinanderfolgenden Kontaktwalzenpaaren 12 befinden sich oberhalb und unterhalb des Bewegungsweges der Kupferlaminate 3 jeweils plattenförmige Anoden 14, die mit dem Pulspol der Spannungsquelle 13 verbunden sind. Sie tragen an den zu den Kontaktwalzenpaaren 12 zeigenden Seiten sowie an der Rückseite eine elektrische Isolierung 16. Diese verhindert eine direkte Elektrolyse zwischen den Anoden 14 und den benachbarten Kontaktwalzenpaaren 12.

Die Kupferlaminate 3 verlassen die Wanne 4 durch den Spalt des Stauwalzenpaars 11, werden von Rollen- bzw. Walzenpaaren 6 in einem Auslaufteil 5 des Gehäuses 1 erfaßt, und verlassen das Gehäuse 1 über einen Austrittsschlitz 17, von wo sie dem nachgeschalteten Modul, zum Beispiel einem Spülmodul, zugeführt werden.

Eine Pumpe 9 entnimmt dem Sumpf 2 des Gehäuses 1 Elektrolyt und speist diesen von unten her in den Innenraum der Wanne 4. Im dynamischen Gleichgewicht zwischen zugefördertem Elektrolyten und aus der Wanne über- bzw. auslaufendem und in den Sumpf 2 zurückströmendem Elektrolyten stellt sich innerhalb der Wanne 4 in der Höhe einer nicht dargestelten Überlaufrinne ein stationärer Pegel 15 des Elektrolyten ein, wie dies in der Zeichnung schematisch dargestellt ist. Diese Art des dynamischen Aufstauens einer Behandlungsflüssigkeit ist in Fachkreisen als "stehende Welle" bekannt.

Die beschriebene Vorrichtung arbeitet wie folgt:

Die schwarz- oder braunoxidierten Kupferlaminate, welche durch den Spalt des Stauwalzenpaares 10 in den in der Wanne 4 aufgestauten Elektrolyten eintreten, gelangen zwischen die Kontaktwalzenpaare 12, wodurch sämtliche metallische Bereiche an der Ober- und Unterseite mit dem Minuspol der Spannungsquelle 13 verbunden, also kathodisch geschaltet werden. Beim Durchlauf zwischen den Anodenplatten 14 entsteht so zwischen diesen und den vorbeiwandernden Kupferlaminaten 3 ein elektrisches Feld, in welchem der in der Wanne 4 aufgestaute Elektrolyt elektrolysiert wird. Die Konzentration des Elektrolyten (beispielsweise 5-prozentiges NaOH) und die Spannung der Spannungsquelle 13 werden so eingestellt, daß sich eine Stromdichte von einigen 10 bis wenigen 100 mA/cm² einstellt. Aufgrund dieser Elektrolyse entwickelt sich an den kathodisch geschalteten oberflächlich oxidierten Metallbereichen der Kupferlaminate 3 zunächst atomarer Wassestoff "in statu nascenti", der mit dem Kupferoxid auf dem schwarz- oder braunoxidierten Kupferlaminat reagiert und dieses reduziert. Die Reduktion braucht nicht vollständig zu erfolgen; es genügt, wenn das zweiwertige Kupfer teilweise zu metallischem Kupfer und teilweise zu einwertigem Kupfer reduziert wird. Überschüssiger atomarer Wasserstoff vereinigt sich in bekannter Weise mit anderen Wasserstoffatomen und unter Ausbildung von Wasserstoffmolekülen, die als Gas entweichen.

An den Anodenplatten 14 entwickelt sich Sauerstoff. Die bei der Elektrolyse entstehenden Gase werden durch eine geeignetet Be- und Entlüftung verdünnt und entsorgt.

Der Abstand zwischen benachbarten Kontaktwalzenpaaren 12 ist auf die Dimensionen der Kupferlaminate 3 so abgestimmt, daß sich letztere während des gesamten Durchganges durch die Wanne 4 zwischen den Stauwalzenpaaren 10 und 11 auf kathodischem Potential befinden. Es findet somit nahezu während des gesamten Durchganges der Kupferlaminate 3 zwischen den Stauwalzenpaaren 10 und 11 eine Elektrolyse und eine elektrochemische Reduktion des Kupferoxides auf den Kupferlaminaten 3 statt.

Bereits nach wenigen Sekunden, beispielsweise nach fünf Sekunden, sind die zuvor schwarz- oder braunoxidierten metallischen Oberflächen der Kupferlaminate 3 derart reduziert bzw. passiviert, daß sie bei einer nachfolgenden Säurebehandlung einen sehr viel höheren Resistenzwert aufweisen, beispielsweise erst nach der sechsfachen Expositionszeit abgetragen sind.

Die Behandlungsdauer wird bei vorgegebener Transportgeschwindigkeit durch die Länge der Wanne 4 - in Bewegungsrichtung gesehen - eingestellt. Sie kann, verglichen mit herkömmlichen Modulen, in denen die Reduktion der Kupferoxidschicht auf rein chemischem Wege erfolgt, erheblich kürzer gehalten werden.

Unter bestimmten Bedingungen ist es auch möglich, dem im Sumpf 2 und in der Wanne 4 befindlichen Elektrolyten auch ein chemisches Reduktionsmittel zuzugeben. Die elektrochemische Reduktion bildet in diesem Falle eine Art "Starter", der das Einsetzen der rein chemischen Reduktionsreaktion beschleunigt. Alternativ ist es auch möglich, der dargestellten Vorrichtung, die ausschließlich elektrochemisch reduziert, ein zweites Modul nachzuschalten, in welchem die vorreduzierten Kupferlaminate 3 durch ein chemisches Reduktionsbad geführt werden, wie dies an und für sich bekannt ist.

Bei der oben im Detail beschriebenen Vorrichtung waren die Kontaktiereinrichtungen als Kontaktwalzen ausgebildet. Statt deren können auch Bürsten oder Bürstenvorhänge eingesetzt werden.

## Patentansprüche

1. Verfahren zur Herstellung von Multilayern, bei welchen das Kupferoxid an den metallischen Bereichen schwarz- oder braunoxidierter Kupferlaminate vor deren Einbindung in die Multilayer zur Vermeidung der Bildung von Pinkringen zumindest teilweise reduziert wird, dadurch gekennzeichnet, daß die Reduktion durch atomaren Wasserstoff erfolgt, der "in statu nascendi" unmittelbar an den Kupferlaminaten (3) dadurch entsteht, daß diese in einem geeigneten Elektrolyten als Kathode einer Elektrolyse geschaltet werden.

2. Verfahren nach Anspruch 1, dadurch gekennzeichnet, daß als Elektrolyt verdünntes NaOH verwendet wird.

3. Verfahren nach Anspruch 1, dadurch gekennzeichnet, daß als Elektrolyt eine Salzlösung verwendet wird.

4. Verfahren nach Anspruch 3, dadurch gekennzeichnet, daß als Elektrolyt eine Kochsalzlösung verwendet wird.

5. Verfahren nach einem der Ansprüche 1 bis 4, dadurch gekennzeichnet, daß die Stromdichte während der Elektrolyse zwischen 1 und 500, vorzugsweise zwischen 20 und 250 mA/cm² gehalten wird.

6. Verfahren nach einem der Ansprüche 1 bis 5, dadurch gekennzeichnet, daß die Kupferlaminate (3) während der Elektrolyse gleichzeitig einem im Elektrolyten gelösten chemischen Reduktionsmittel ausgesetzt werden.

7. Verfahren nach einem der Ansprüche 1 bis 5, dadurch gekennzeichnet, daß die Kupferlaminate (3) nach einer anfänglichen elektrochemischen Reduktion einer chemischen Reduktion durch ein Reduktionsmittel unterzogen werden.

8. Verwendung einer Vorrichtung mit
a) einem Gehäuse (1);
b) einem Transportsystem (12), welches die Kupferlaminate (3) in horizontaler Richtung durch die Vorrichtung fördert;
c) einer Einrichtung (4), welche das Kupferoxid an den metallischen Bereichen der schwarz- oder braunoxidierten Kupferlaminate vor deren Einbindung in die Multilayer zur Vermeidung der Bildung von Pinkringen zumindest teilweise reduziert und eine Behandlungskammer (4) umfaßt, welche in dynamischem Gleichgewicht von Zufluß und Abfluß mit einem in der Elektrolyse Wasserstoff entwickelnden Elektrolyten bis zu einem bestimmten Pegel (15) befüllbar ist, wobei die Kupferlaminate (3) vom Transportsystem (6, 12) unterhalb des Pegels (15) des Elektrolyten durch die Behandlungskammer (4) hindurchgeführt werden;
e) einer Spannungsquelle (13);
f) mindestens einer Kontaktiereinrichtung (12), die innerhalb der Behandlungskammer (4) angeordnet ist, sich senkrecht zu Bewegungsrichtung der Kupferlaminate (3) über deren ganze Breite erstreckt und mit dem Minuspol der Spannungsquelle (13) verbunden ist;
g) mindestens einer Anode (14), die in der Nähe des Bewegungsweges der Kupferlaminate (3) angeordnet und mit dem Pluspol der Spannungsquelle (13) verbunden ist,
zur Durchführung eines Verfahrens nach einem der Ansprüche 1 bis 7.

9. Verwendung der Vorrichtung nach Anspruch 8, bei welcher mehrere Kontaktiereinrichtungen (12) und Anoden (14) in Bewegungsrichtung der Kupferlaminate (3) hintereinander angeordnet sind, zur Durchführung eines Verfahrens nach einem der Ansprüche 1 bis 7.

10. Verwendung der Vorrichtung nach Anspruch 8, bei welcher der Abstand benachbarter Kontaktiereinrichtungen (12) kleiner als die Längsabmessung, vorzugsweise kleiner als die halbe Längsabmessung, der Kupferlaminate (3) ist, zur Durchführung eines Verfahrens nach einem der Ansprüche 1 bis 7.

11. Verwendung der Vorrichtung nach Anspruch 9 oder 10, bei welcher die Anode(n) (14) zwischen den Kontaktiereinrichtungen (12) angeordnet ist (sind), zur Durchführung eines Verfahrens nach einem der Ansprüche 1 bis 7.

12. Verwendung der Vorrichtung nach Anspruch 11, bei welcher die Anode(n) (14) auf den nicht den Bewegungsweg der Kupferlaminate (3) zugewandten Seiten elektrisch isoliert (16) ist (sind), zur Durchführung eines Verfahrens nach einem der Ansprüche 1 bis 7.

13. Verwendung der Vorrichtung nach einem der Ansprüche 8 bis 12, bei welcher die Kontaktiereinrichtung(en) (12) jeweils von einer Kontaktwalze gebildet ist (sind), zur Durchführung eines Verfahrens nach einem der Ansprüche 1 bis 7.

14. Verwendung der Vorrichtung nach einem der Ansprüche 8 bis 12, bei welcher die Kontaktiereinrichtung(en) jeweils von einer Bürste oder einem Bürstenvorhang gebildet ist (sind), zur Durchführung eines Verfahrens nach einem der Ansprüche 1 bis 7.

15. Verwendung der Vorrichtung nach einem der Ansprüche 8 bis 14, bei welcher der Elektrolyt verdünntes NaOH ist, zur Durchführung eines Verfahrens nach einem der Ansprüche 1 bis 7.

16. Verwendung der Vorrichtung nach einem der Ansprüche 8 bis 14, bei welcher der Elektrolyt eine Salzlösung ist, zur Durchführung eines Verfahrens nach einem der Ansprüche 1 bis 7.

17. Verwendung der Vorrichtung nach Anspruch 16, bei welcher der Elektrolyt eine Kochsalzlösung ist, zur Durchführung eines Verfahrens nach einem der Ansprüche 1 bis 7.

18. Verwendung der Vorrichtung nach einem der Ansprüche 8 bis 17, bei welcher der Elektrolyt ein chemisches Reduktionsittel enthält, zur Durchführung eines Verfahrens nach einem der Ansprüche 1 bis 7.

19. Verwendung der Vorrichtung nach einem der Ansprüche 8 bis 17, bei welcher eine zweite Behandlungskammer vorgesehen ist, welche in Bewegungsrichtung der Kupferlaminate (3) hinter der ersten Behandlungskammer (4) angeordnet ist und in welcher die Kupferlaminate (3) einer Lösung eines chemischen Reduktionsmittels aussetzbar sind, zur Durchführung eines Verfahrens nach einem der Ansprüche 1 bis 7.

## Claims

1. A process for the production of multilayers wherein the copper oxide on the metallic zones of black- or brown-oxidized copper laminates is at least partially reduced prior to the integration of said laminates into the multilayers to avoid the formation of pink rings, characterised in that the reduction is effected by atomic hydrogen which forms "in statu nascendi" directly on the copper laminates in that in a suitable electrolyte the copper laminates (3) are connected as cathode of an electrolysis system.

2. A process according to Claim 1, characterised in that diluted NaOH is used as electrolyte.

3. A process according to Claim 1, characterised in that a salt solution is used as electrolyte.

4. A process according to Claim 3, characterised in that a common salt solution is used as electrolyte.

5. A process according to one of Claims 1 to 4, characterised in that the current density during the electrolysis is maintained at between 1 and 500, preferably 20 and 250 mA/cm².

6. A process according to one of Claims 1 to 5, characterised in that during the electrolysis the copper laminates (3) are simultaneously exposed to a chemical reduction agent dissolved in the electrolyte.

7. A process according to one of Claims 1 to 5, characterised in that following an initial electrochemical reduction the copper laminates (3) are subjected to a chemical reduction by a reduction agent.

8. Use of a device comprising:
a) a housing (1);
b) a transport system (12) which conveys the copper laminates (3) horizontally through the device;
c) an apparatus (4) which at least partially reduces the copper oxide on the metallic zones of the black- or brown-oxidized copper laminates prior to the integration of said laminates into the multilayers to avoid the formation of pink rings and which comprises a treatment chamber (4) which, with dynamic equilibrium between inflow and outflow, can be filled to a specified level (15) with an electrolyte which develops hydrogen during the electrolysis, the copper laminates (3) being conducted through the treatment chamber (4) by the transport system (6, 12) below the level (15) of the electrolyte;
e) a voltage source (13);
f) at least one contacting device (12) which is arranged inside the treatment chamber (4), extends at right angles to the direction of movement of the copper laminates (3) over their entire breadth, and is connected to the minus pole of the voltage source (13);
g) at least one anode (14) which is arranged in the vicinity of the path of movement of the copper laminates (3) and is connected to the plus pole of the voltage source (13),
for the implementation of a process according to one of Claims 1 to 7.

9. Use of the device according to Claim 8, wherein a plurality of contacting devices (12) and anodes (14) are arranged in series in the direction of movement of the copper laminates (3), for the implementation of a process according to one of Claims 1 to 7.

10. Use of the device according to Claim 8, wherein the distance between adjacent contacting devices (12) is smaller than the length dimension of the copper laminates (3), preferably smaller than half their length dimension, for the implementation of a process according to one of Claims 1 to 7.

11. Use of the device according to Claim 9 or 10, wherein the anode(s) (14) is(are) arranged between the contacting devices (12), for the implementation of a process according to one of Claims 1 to 7.

12. Use of the device according to Claim 11, wherein the anode(s) (14) is(are) electrically insulated (16) on their sides not facing towards the path of movement of the copper laminates (3), for the implementation of a process according to one of Claims 1 to 7.

13. Use of the device according to one of Claims 8 to 12, wherein the contacting device(s) (12) is(are) in each case formed by a contact roller, for the implementation of a process according to one of Claims 1 to 7.

14. Use of the device according to one of Claims 8 to 12, wherein the contacting device(s) is(are) in each case formed by a brush or a brush curtain, for the implementation of a process according to one of Claims 1 to 7.

15. Use of the device according to one of Claims 8 to 14, wherein the electrolyte is diluted NaOH, for the implementation of a process according to one of Claims 1 to 7.

16. Use of the device according to one of Claims 8 to 14, wherein the electrolyte is a salt solution, for the implementation of a process according to one of Claims 1 to 7.

17. Use of the device according to Claim 16, wherein the electrolyte is a common salt solution, for the implementation of a process according to one of Claims 1 to 7.

18. Use of the device according to one of Claims 8 to 17, wherein the electrolyte contains a chemical reduction agent, for the implementation of a process according to one of Claims 1 to 7.

19. Use of the device according to one of Claims 8 to 17, wherein a second treatment chamber is provided which is arranged downstream of the first treatment chamber (4) in the direction of movement of the copper laminates (3) and in which the copper laminates (3) can be exposed to a solution of a chemical reduction agent, for the implementation of a process according to one of Claims 1 to 7.

## Revendications

1. Procédé pour la fabrication de multicouches, réduisant au moins en partie l'oxyde de cuivre se trouvant sur les parties métalliques de laminés de cuivre oxydés en noir ou brun, avant l'insertion de ceux-ci dans les multicouches pour empêcher la formation d'anneaux roses, **caractérisé en ce que** la réduction s'effectue au moyen d'hydrogène atomique, produit « in statu nascendi » directement sur les laminés de cuivre (3), par le fait que ceux-ci soient commutés dans un électrolyte approprié comme cathode d'une électrolyse.

2. Procédé selon la revendication 1, **caractérisé en ce que** du NaOH dilué est utilisé comme électrolyte.

3. Procédé selon la revendication 1, **caractérisé en ce qu**'une solution saline est utilisée comme électrolyte.

4. Procédé selon la revendication 3, **caractérisé en ce qu**'une solution de sel de cuisine est utilisée comme électrolyte.

5. Procédé selon l'une des revendications 1 à 4, **caractérisé en ce que** la densité de courant est maintenue de 1 à 500 mA/cm² pendant l'électrolyse, de préférence de 20 à 250 mA/cm².

6. Procédé selon l'une des revendications 1 à 5, **caractérisé en ce que** les laminés de cuivre (3) pendant l'électrolyse sont exposés simultanément à un agent réducteur chimique dilué dans l'électrolyte.

7. Procédé selon l'une des revendications 1 à 5, **caractérisé en ce que** les laminés de cuivre (3) sont soumis d'abord à une réduction électrochimique puis à une réduction chimique au moyen d'un agent réducteur.

8. Utilisation d'un dispositif composé de
a) un boîtier (1) ;
b) un système de transport (12) qui transporte les laminés de cuivre (3) en sens horizontal à travers le dispositif ;
c) un arrangement (4) qui réduit au moins en partie l'oxyde de cuivre se trouvant sur les parties métalliques des laminés de cuivre oxydés en noir ou brun avant leur insertion dans les multicouches pour empêcher la formation d'anneaux roses et qui comprend une chambre de traitement (4) qui, dans un équilibre dynamique d'afflux et d'écoulement, peut être remplie jusqu'à un certain niveau (15) avec un électrolyte dégageant l'hydrogène dans l'électrolyse, les laminés de cuivre (3) étant amenés à traverser la chambre de traitement (4) par le système de transport (6, 12) sous le niveau (15) de l'électrolyte;
d) une source de tension (13),
e) au moins un dispositif de contact (12) placé dans la chambre de traitement (4), qui s'étend perpendiculairement au sens de déplacement des laminés de cuivre (3) sur toute leur largeur et relié au pôle négatif de la source de tension (13);
f) au moins une anode (14) placée à proximité de la trajectoire de déplacement des laminés de cuivre (3) et reliée au pôle positif de la source de tension (13),
pour la mise en oeuvre du procédé selon l'une des revendications 1 à 7.

9. Utilisation du dispositif selon la revendication 8, dans lequel plusieurs dispositifs de contact (12) et plusieurs anodes (14) sont placés les uns derrière les autres dans le sens de déplacement des laminés de cuivre (3) pour la mise en oeuvre du procédé selon l'une des revendications 1 à 7.

10. Utilisation du dispositif selon la revendication 8, dans lequel l'écart entre les dispositifs de contact (12) adjacents est inférieur à la longueur des laminés de cuivre (3), de préférence inférieur à la moitié de la longueur, pour la mise en oeuvre du procédé selon l'une des revendications 1 à 7.

11. Utilisation du dispositif selon la revendication 9 ou 10, dans lequel les (l') anode(s) (14) est(sont) placée(s) entre les dispositifs de contact (12), pour la mise en oeuvre du procédé selon l'une des revendications 1 à 7.

12. Utilisation du dispositif selon la revendication 11, dans lequel les(l') anode(s) (14) est(sont) isolée(s) électriquement sur les côtés qui ne font pas face à la trajectoire de déplacement des laminés de cuivre (3), pour la mise en oeuvre du procédé selon l'une des revendications 1 à 7.

13. Utilisation du dispositif selon l'une des revendications 8 à 12, dans lequel le(s) dispositif(s) de contact (12) est(sont) formé(s) respectivement d'un rouleau de contact, pour la mise en oeuvre du procédé selon l'une des revendications 1 à 7.

14. Utilisation du dispositif selon l'une des revendications 8 à 12, dans lequel le(s) dispositif(s) de contact est(sont) formé(s) respectivement d'un balai ou d'un rideau de balai, pour la mise en oeuvre du procédé selon l'une des revendications 1 à 7.

15. Utilisation du dispositif selon l'une des revendications 8 à 14, dans lequel l'électrolyte est du NaOH dilué, pour la mise en oeuvre du procédé selon l'une des revendications 1 à 7.

16. Utilisation du dispositif selon l'une des revendications 8 à 14, dans lequel l'électrolyte est une solution saline, pour la mise en oeuvre du procédé selon l'une des revendications 1 à 7.

17. Utilisation du dispositif selon la revendication 16, dans lequel l'électrolyte est une solution de sel de cuisine, pour la mise en oeuvre du procédé selon l'une des revendications 1 à 7.

18. Utilisation du dispositif selon l'une des revendications 8 à 17, dans lequel l'électrolyte contient un agent réducteur chimique, pour la mise en oeuvre du procédé selon l'une des revendications 1 à 7.

19. Utilisation du dispositif selon l'une des revendications 8 à 17, dans lequel une seconde chambre de traitement est prévue, qui est placée dans le sens de déplacement des laminés de cuivre (3) derrière la première chambre de traitement (4) et dans laquelle les laminés de cuivre (3) peuvent être exposés à une solution d'un agent réducteur chimique, pour la mise en oeuvre du procédé selon l'une des revendications 1 à 7.
